# EUROPÄISCHE PATENTSCHRIFT

(11) **EP 3 685 480 B1**
(45) Veröffentlichungstag und Bekanntmachung des Hinweises auf die Patenterteilung: **09.08.2023**
(21) Anmeldenummer: 18785494.8
(22) Anmeldetag: 04.09.2018
(51) Int. Cl.: H01S 5/042

(54) **INTEGRIERTE LASERTREIBERSCHALTUNG ZUM SCHALTEN EINES PULSSTROMS FÜR EINE LASERDIODE**
INTEGRATED LASER DRIVER CIRCUIT FOR SWITCHING A PULSE CURRENT FOR A LASER DIODE
CIRCUIT DE COMMANDE DE LASER INTÉGRÉ POUR LA COMMANDE D'UN COURANT PULSÉ POUR UNE DIODE LASER

(30) Priorität: 19.09.2017 DE 102017121713
(43) Veröffentlichungstag der Anmeldung: 29.07.2020
(73) Patentinhaber: iC-Haus GmbH, 55294 Bodenheim (DE)
(72) Erfinder: BURKARD, Ralf, 65321 Kemel (DE)
(74) Vertreter: Feder Walter Ebert
(86) Internationale Anmeldenummer: PCT/DE2018/100750
(87) Internationale Veröffentlichungsnummer: WO 2019/057236

(56) Entgegenhaltungen:
- DE-A1-102009 060 873
- JP-A- H1 065 239
- US-B1- 6 618 406

## Beschreibung

Die vorliegende Erfindung betrifft eine integrierte Lasertreiberschaltung zum Schalten eines Pulsstroms für eine Laserdiode mit einer Mehrzahl von Unterschalteinheiten zum Erzeugen jeweils eines Teilstroms mit einem Schalter zum Pulsen des Teilstroms, wobei die Unterschalteinheiten zur Erzeugung des Pulsstroms zueinander parallel geschaltet sind. Die Erfindung betrifft ferner ein Lasersystem mit mindestens einer Laserdiode und mindestens einer integrierten Lasertreiberschaltung.

Integrierte Lasertreiberschaltungen werden in vielen Bereichen der Technik zum Schalten von hohen Strömen, insbesondere von hohen Pulsströmen, für Anwendungen mit einer oder mehreren Laserdioden eingesetzt. So können entsprechende Lasersysteme in Time of Flight-Anwendungen, in der Sicherheitstechnik, aber auch beispielsweise in der Automobiltechnik, etwa im Zusammenhang mit LIDAR-Sensoren (light detection and ranging) eingesetzt werden. Für die Verwendung in entsprechenden Anwendungen ist es erforderlich, dass Ströme zuverlässig und schnell geschaltet werden.

Aus der DE 10 2009 060 873 A1 ist beispielsweise eine integrierte Lasertreiberschaltung zum Schalten eines Pulsstroms für eine Laserdiode bekannt. Die Lasertreiberschaltung weist eine Mehrzahl von Unterschalteinheiten auf, welche jeweils zum Erzeugen eines Teilstroms vorgesehen sind, wobei jede Unterschaltereinheit einen Schalter aufweist, mittels welchem der Teilstrom gepulst werden kann. Die Unterschalteinheiten sind wiederum zueinander parallel geschaltet, so dass sich die Teilströme der Unterschalteinheiten zu einem Gesamtpulsstrom addieren lassen.

Derartige integrierte Lasertreiberschaltungen haben sich im Einsatz zwar durchaus bewährt, allerdings geraten diese Schaltungen, insbesondere bei Hochstromanwendungen mit sehr hohen Strömen im Ampere-Bereich durch unterschiedliche Schaltzeitpunkte der Unterschalteinheiten an ihre Grenzen, so dass insbesondere die erforderlichen Schaltzeiten und Pulsformen nicht mehr realisiert werden können.

Weitere Lasertreiberschaltungen werden in der JP H10 065239 A und der US 6 618 406 B1 offenbart.

Vor diesem Hintergrund stellt sich die Erfindung die **Aufgabe**, eine integrierte Lasertreiberschaltung anzugeben, mittels welcher auch sehr hohe Pulsströme in sehr kurzer Zeit geschaltet werden können.

Diese Aufgabe wird bei einer integrierten Lasertreiberschaltung der eingangs genannten Art mit den Merkmalen des Anspruchs 1 **gelöst**.

Erfindungsgemäß ist vorgesehen, dass in den Unterschalteinheiten jeweils ein Energiespeicher zum Bereitstellen der zum Schalten des Schalters erforderlichen Schaltenergie integriert ist.

Mit Hilfe eines Energiespeichers innerhalb der Unterschalteinheit ist es möglich, auch hohe Pulsströme pro Unterschalteinheit, insbesondere im Ampere-Bereich, beispielsweise im Bereich von 1-10A, gleichmäßig und schnell im Verbund der Unterschalteinheiten zu schalten. Die zum Schalten des Schalters erforderliche Schaltenergie kann auf diese Weise innerhalb der Unterschalteinheiten vorgehalten werden und direkt zur Verfügung gestellt werden kann. Auf diese Weise kann ein Zusammenbrechen der lokalen Versorgungsspannung verhindert und diese so stabilisiert werden. Der Energiespeicher kann dann bei einem hohen Strom- bzw. Leistungsbedarf, wie dieser während des Schaltvorgangs auftritt, als Spannungs- und/oder Energiequelle wirken. Darüber hinaus kann eine gegenseitige Beeinflussung der einzelnen Unterschalteinheiten verhindert werden, wodurch sich ein gleichmäßiger Schaltvorgang erzeugen lässt. Insbesondere können Pulse mit hoher Flankensteilheit erzeugt werden.

Erfindungsgemäß ist vorgesehen, dass jede Unterschalteinheit einen Versorgungsanschluss zum Anlegen einer Versorgungsspannung und einen Masseanschluss aufweist, wobei der Energiespeicher zwischen dem Versorgungsanschluss und den Masseanschluss geschaltet ist. Durch eine Verschaltung des Energiespeichers zwischen den Versorgungsanschluss und den Masseanschluss kann die Versorgungsspannung, insbesondere während des Schaltvorgangs, stabilisiert werden. Der Energiespeicher kann bevorzugt parallel zur Versorgungsspannung geschaltet sein, so dass der Energiespeicher bei Bedarf als stützende Spannungs- und/oder Energiequelle wirken kann. Stromspitzen können auf diese Weise zuverlässig ausgeglichen und die zum Umladen des Schalters erforderliche Schaltenergie lokal bereitgestellt werden.

In konstruktiver Hinsicht ist erfindungsgemäß vorgesehen, dass der Energiespeicher als mindestens ein Kondensator ausgebildet ist. Dieser weist besonders bevorzugt eine niedrige Impedanz auf. Zusätzlich können störende zeitlich begrenzte Überspannungen aufgenommen und so deren Ausbreitung und schädliche Wirkung vermindert werden. Besonders bevorzugt ist, wenn der Kondensator eine Kapazität im Nanofarad- oder im Picofaradbereich, besonders bevorzugt jedoch im Picofaradbereich, aufweist. Um parasitäre Effekte zu vermeiden, hat es sich ferner als vorteilhaft erwiesen, wenn der Energiespeicher über einen kurzen und induktivitätsarmen Anschluss angeschlossen ist. Durch entsprechend kurz ausgebildete Leitungen und/oder groß gewählte Querschnitte der Leiterbahnen kann der Energiespeicher niederinduktiv angebunden werden. Durch die räumliche Nähe zum jeweiligen Schalter werden Induktivitäten minimiert, weshalb der notwendige Schaltstrom zum Einschalten des Schalters sofort geliefert werden kann und so Spannungsabfälle in Grenzen gehalten werden. Gleichzeitig können die hohen Ströme nur auf dem kurzen Weg fließen, so dass die dadurch hervorgerufenen EMV-Störungen stark bedämpft werden können. Instabilitäten und ein Aufschwingen der integrierten Lasertreiberschaltung können auf diese Weise verhindert werden.

Gemäß einer konstruktiven Ausgestaltung ist vorgesehen, dass der Kondensator als Metall-Isolator-Metall (MIM)-Kondensator und/oder als Fringe-Kondensator und/oder als Poly-Poly-Kondensator und/oder als Diffusions-Kondensator und/oder als Gate-Kondensator ausgebildet ist. Als vorteilhaft hat es sich erwiesen, wenn als Energiespeicher Kondensatoren verwendet werden, welche niederohmig ausgestaltet sind. Auf diese Weise kann ein hoher Kapazitätsbelag erreicht werden. Als besonders vorteilhaft hat sich jedoch die Verwendung eines Metall-Isolator-Metall-Kondensators erwiesen. Entsprechende MIM-Kondensatoren bieten den Vorteil eines geringen Innenwiederstands sowie einer geringen parasitären Induktivität, die insoweit im Wesentlichen einen idealen Plattenkondensator bilden. Bevorzugt kann jedoch auch eine Kombination sämtlicher vorgenannter Kondensatorarten sowie, soweit verfügbar, auch weitere Kondensatoren einzeln oder in Kombination verwendet werden. Dabei ist es besonders bevorzugt, wenn der auf der integrierten Lasertreiberschaltung zur Verfügung stehende Bauraum möglichst effektiv ausgenutzt werden kann. Durch die Kombination verschiedenartiger Kapazitäten kann der Kapazitätsbelag zusätzlich erhöht werden.

Ferner vorteilhaft ist, wenn bei einem Metall-Isolator-Metall-Kondensator zumindest eine Elektrode des Kondensators durch eine in der Unterschalteinheit vorhandene Metallfläche gebildet wird. Besonders bevorzugt ist, wenn beide Elektroden des Kondensators durch in der Unterschalteinheit vorhandene Metallflächen gebildet werden. Eine Metallfläche kann beispielsweise eine Leiterbahn oder dergleichen sein. Während des Herstellungsprozesses kann dann auf die vorhandenen Metallflächen eine Isolatorschicht und, sofern nur eine Metallfläche vorhanden ist, eine Gegenelektrode aufgebracht werden. Auf diese Weise können bereits in der Unterschalteinheit vorhandene Strukturen mehrfach verwendet werden, wodurch sich die Baugröße der integrierten Lasertreiberschaltung weiter verringern lässt.

Gemäß einer weiteren Ausgestaltung ist vorgesehen, dass jede Unterschalteinheit zur Erzeugung des Teilstroms eine Stromquelle, insbesondere als Transistor, aufweist, welche über den Schalter schaltbar ist. Bevorzugt ist die Stromquelle als Feldeffekttransistor ausgebildet. Die Stromquelle und der Schalter können zueinander in Reihe geschaltet sein. Besonders bevorzugt ist die Stromquelle annähernd als Konstantstromquelle ausgebildet, welche einen konstanten Teilstrom erzeugen kann und welche zur Erzeugung eines gepulsten Teilstroms über den Schalter geschaltet werden kann.

In diesem Zusammenhang ist es von Vorteil, wenn jede Unterschalteinheit zur Einstellung des Teilstroms einen Referenzeingang aufweist, welcher mit der Stromquelle verbunden ist. Die Referenzeingänge der einzelnen Unterschalteinheiten können dabei bevorzugt auf dem Substrat zusammengeschaltet sein. Der Referenzeingang kann mit einer Referenzspannung beaufschlagt werden, beispielsweise über eine Gleichspannungsquelle. Der Teilstrom stellt dabei eine Funktion der Referenzspannung dar, weshalb auch der Pulsstrom der Laserdiode eine Funktion der Referenzspannung darstellt. Die Referenzspannung kann über den Referenzeingang dem Gateanschluss des als Stromquelle fungierenden Transistors zugeführt werden. Zur Einstellung des Arbeitspunktes können zwischen dem Referenzeingang und der Stromquelle zusätzlich eine Impedanz und/oder eine aktive Schaltung vorgesehen sein. Auf diese Weise kann der Arbeitspunkt der Stromquelle jeder Unterschalteinheit und damit die Höhe des Teilstroms eingestellt werden.

Besonders bevorzugt ist, wenn die Stromquelle und der Schalter eine Teilstromerzeugungseinheit bilden. Die Teilstromerzeugungseinheit kann einen Teilstrom zur Verfügung stellen, welcher in seiner Höhe in Abhängigkeit des Gesamtpulsstroms eingestellt werden kann. Insbesondere kann auch die Pulsung eingestellt werden. Die Teilströme der einzelnen Teilstromerzeugungseinheiten der jeweiligen Unterschalteinheiten können addiert werden, so dass sich dann ein definierter Gesamtpulsstrom ergibt. Besonders bevorzugt ist, wenn die Teilstromerzeugungseinheiten derart angesteuert und/oder eingestellt werden, dass diese alle den gleichen Teilstrom liefern. Hierdurch kann ein gleichmäßiges Schaltverhalten erzielt werden.

Ferner vorteilhaft ist mindestens eine Synchronisationseinheit zur Synchronisierung der Eingangs- und Ausgangssignale, welche zu den Unterschalteinheiten parallel geschaltet ist. Mit Hilfe einer solchen Synchronisationseinheit können durch die Schaltung selbst hervorgerufene Verzögerungen, einschließlich möglicher Veränderungen durch Temperatureinflüsse, Alterung oder dergleichen, zwischen dem Eingangssignal und dem resultierenden Ausgangssignal ermittelt und entsprechend ausgewertet werden. Auf diese Weise lässt sich ein Synchronisationssignal erzeugen, mittels welchem parasitäre Effekte vermieden werden können, und das zeitgleich zum Ausgangsstrom des Lasertreibers zur Verfügung steht. Auf diese Weise können aufwendige Synchronisationsprozesse vermieden werden. Die Synchronisation der Signale kann direkt aus der integrierten Lasertreiberschaltung abgeleitet werden.

In diesem Zusammenhang ist es von Vorteil, wenn die Synchronisationseinheit das gleiche Zeitverhalten wie die Unterschalteinheiten aufweist. Auf diese Weise kann auf einfache Weise das zeitliche Verhalten der Unterschalteinheiten und insbesondere in den Unterschalteinheiten entstehende Verzögerungen ermittelt werden und so berücksichtigt werden. Insbesondere kann so auch eine Temperaturunabhängigkeit der integrierten Lasertreiberschaltung realisiert werden.

Gemäß einer bevorzugten Ausgestaltung ist vorgesehen, dass die Synchronisationseinheit und die Unterschalteinheiten hinsichtlich der Erzeugung des Teilstroms im Wesentlichen identisch ausgebildet sind. Insbesondere hat es sich als vorteilhaft erwiesen, wenn die Synchronisationseinheit ebenfalls eine Teilstromerzeugungseinheit aufweist, welche die gleichen Elemente wie die Teilstromerzeugungseinheiten der Unterschalteinheiten aufweist. Bevorzugt können auch sämtliche zusätzlichen Elemente, wie Impedanzen, aktive Schaltungen oder dergleichen in identischer Weise vorgesehen sein. Die Synchronisationseinheit kann sich dabei im Wesentlichen von den Unterschalteinheiten dadurch unterscheiden, dass deren Ausgang nicht mit den Ausgangssignalen der Unterschalteinheiten zusammengeführt ist, sondern getrennt als Synchronisationsausgang herausgeführt ist. Auf diese Weise kann ein elektrisches Signal erzeugt werden, welches hinsichtlich des Zeitverhaltens dem der Unterschalteinheiten entspricht. Dieses kann dann jedoch für einen Synchronisationsvorgang und nicht zur Erzeugung des Pulsstroms herangezogen werden.

Eine weitere Ausgestaltung der Erfindung sieht vor, dass die Synchronisationseinheit mindestens zwei Teilstromerzeugungseinheiten mit jeweils einem Ausgang aufweist, die parallel oder antiparallel schalten. Besonders vorteilhaft ist dabei, wenn die in den Teilstromerzeugungseinheiten vorgesehenen Schaltelemente im Wesentlichen gegenüber den Teilstromerzeugungseinheiten der Unterschalteinheiten halbiert werden. In diesem Fall kann sich dann durch die Doppelung hälftiger Elemente das gleiche Zeit- und Schaltverhalten ergeben, wie bei einem einzigen Element. Auch hier kann aufgrund der Verschaltung ein elektrisches Verhalten realisiert werden, welches im Wesentlichen mit dem der Unterschalteinheiten identisch ist. Durch das Vorsehen von zwei Teilstromerzeugungseinheiten, welche antiparallel schalten, bietet sich jedoch der Vorteil, dass die Signale differenziell genutzt werden können. Dies bietet insbesondere in schaltungstechnischer Hinsicht Vorteile.

In Weiterbildung der Erfindung wird vorgeschlagen, dass die Unterschalteinheiten und/oder die Synchronisationseinheit mittels einer Steuerschaltung derart ansteuerbar sind, dass alle Unterschalteinheiten und/oder die Synchronisationseinheit gleichzeitig schaltbar sind. Insoweit ist es nicht erforderlich, jede Unterschalteinheit und/oder die Synchronisationseinheit einzeln anzusteuern. Hierdurch können zeitliche Verzögerungen und Ungleichmäßigkeiten im Schaltverhalten verhindert werden. Besonders bevorzugt ist, wenn ein Steuersignal zeitgleich an allen Eingangsanschlüssen der Unterschalteinheiten und/oder der Synchronisationseinheit anliegt. Damit kann sichergestellt werden, dass die Gesamtfunktion der integrierten Lasertreiberschaltung durch eine Addition gleichwertiger Einzelfunktionen ohne gegenseitige Beeinflussungen oder Störungen definiert ist. Bevorzugt ist, wenn die Steuerschaltung auf dem Substrat angeordnet ist. Auf diese Weise kann eine kompakte Bauweise und eine schnelle und präzise Ansteuerung der Unterschalteinheiten und/oder der Synchronisationseinheit erreicht werden.

In diesem Zusammenhang ist es besonders vorteilhaft, wenn die Steuerschaltung als binäre Verstärkerbaumstruktur ausgebildet ist. Auf diese Weise lässt sich die Ansteuerung der Unterschalteinheiten noch einmal präzisieren. Hierdurch kann die Gleichzeitigkeit der Schaltvorgänge weiter verbessert werden. Die Baumstruktur kann dabei bevorzugt Verzögerungs- und/oder Verstärkungselemente aufweisen. Durch eine solche Baumstruktur kann eine Vielzahl von Unterschalteinheiten und/oder die Synchronisationseinheit mit einem einzigen Steuersignal schnell und effizient angesteuert werden.

Eine weitere Ausgestaltung der Erfindung sieht vor, dass die Schaltzeiten der Unterschalteinheiten und/oder der Synchronisationseinheit im Pico-Sekundenbereich liegen. Durch die Ausgestaltung der Unterschalteinheiten und/oder der Synchronisationseinheit mit einem integrierten Energiespeicher können die Schaltzeiten gegenüber bestehenden Lösungen deutlich verkürzt werden. Auf diese Weise können auch hohe Ströme im Ampere-Bereich schnell geschaltet werden. Insbesondere können mit der integrierten Lasertreiberschaltung Schaltzeiten im Subnanosekunden-Bereich erzielt werden. Des Weiteren können Ströme im Bereich von hundert Milli-Ampere bis zu einigen Ampere, bevorzugt zwischen 100 mA und 10 A, besonders bevorzugt zwischen 1 und 6 A, pro Unterschalteinheit geschaltet werden.

Mit der Parallelschaltung von mehreren Unterschalteinheiten, bevorzugt mehr als 10 Unterschalteinheiten, insbesondere bis zu einigen hundert Unterschalteinheiten, ergeben sich Lasertreiber im Bereich von einigen Ampere bis zu einigen hundert A mit dem Schaltverhalten der Unterschalteinheiten. Ferner vorteilhaft ist die Parallelschaltung mehrerer Unterschalteinheiten mit eingebundenen Synchronisationseinheiten innerhalb einer Reihe oder einer Matrix, insbesondere auch mehrreihig oder in mehreren Blöcken auf einem einzigen Halbleitersubstrat, aus denen mehrkanalige Laser, insbesondere Laserbarren oder mehrkanalige VCSEL oder VeCSEL angesteuert werden. Dies ist insbesondere für Anwendungen, beispielsweise im LIDAR-Bereich, bei Time of Flight-Anwendungen oder dergleichen von Vorteil.

Ferner vorteilhaft ist, wenn die Schaltung als High-Side-Treiberschaltung oder als Low-Side-Treiberschaltung ausgebildet ist. Bei einer Ausgestaltung als Low-Side-Treiberschaltung wird mittels des Schalters die Last insbesondere die Kathode einer Laserdiode gegen Masse geschaltet. Bei einer High-Side-Treiberschaltung hingegen schaltet der Schalter die Last insbesondere die Anode einer Laserdiode gegen die Versorgungsspannung. Die Ausgestaltung als Low-Side-Treiberschaltung bietet den Vorteil, dass die Steuerschaltung einfacher ausgestaltet werden kann, als die beispielsweise bei einer High-Side-Treiberschaltung der Fall ist. Allerdings sind mehrkanalige Laser oft mit gemeinsamer Kathode ausgeführt und erfordern dann die Ausgestaltung als High-Side-Treiberschaltung.

Eine in diesem Zusammenhang vorteilhafte Ausgestaltung sieht vor, dass der Energiespeicher in einer High-Side-Treiberschaltung als Bootstrap-Kondensator ausgebildet ist. Mittels des Bootstrap-Kondensators kann eine niederinduktive und niederohmige Pufferung des Energiebedarfs für einen Schaltvorgang bereitgestellt werden.

Bei einem Lasersystem der eingangs genannten Art wird die Aufgabe dadurch g e l ö s t, dass die integrierte Lasertreiberschaltung nach einem der zuvor beschriebenen Ausführungsbeispiele ausgebildet ist. Es ergeben sich die gleichen Vorteile, welche bereits im Zusammenhang mit der integrierten Lasertreiberschaltung erörtert wurden. Dabei können sämtliche Merkmale allein oder im Kombination Anwendung finden.

Eine vorteilhafte Ausgestaltung des Lasersystems sieht vor, dass die Laserdiode auf der integrierten Schaltung angeordnet ist. Auf diese Weise kann die Gesamtbaugröße weiter verringert werden. Es ergibt sich eine in sich geschlossene Schaltung auf einem Substrat. Insoweit kann das komplette Lasersystem als ein Bauteil realisiert werden.

Bevorzugt ist ferner, wenn die integrierte Lasertreiberschaltung auf einem Substrat angeordnet ist und die Laserdiode wärmeleitend über Stacked Vias mit dem Substrat verbunden ist. Auf diese Weise können auch sehr hohe Ströme im Ampere-Bereich realisiert werden, ohne dass es zu Problemen aufgrund von Überhitzung kommen kann. Die Wärme kann auf diese Weise abgeleitet werden.

Ferner vorteilhaft ist, wenn ein Laserpuls durch zwei insbesondere phasenverschobene Eingangssignale erzeugbar ist. Auf diese Weise kann eine höhere Flankensteilheit und damit kürzere Schaltzeiten realisiert werden. Es gibt eine schneller schaltende und präzisere Ansteuerung für die Laserdiode.

Sämtliche der zuvor im Zusammenhang mit dem Lasersystem beschriebenen Merkmale können auch allein oder in Kombination bei der integrierten Lasertreiberschaltung Anwendung finden. Auch hier ergeben sich die gleichen Vorteile, welche im Zusammenhang mit dem Lasersystem beschrieben wurden.

Weitere Einzelheiten der Erfindung sollen nachfolgend anhand der in den Figuren dargestellten Ausführungsbeispiele näher erläutert werden. Hierin zeigt:
- Fig. 1: ein Ersatzschaltbild einer integrierten Lasertreiberschaltung mit mehreren Unterschalteinheiten und einer Laserdiode;
- Fig. 2: ein Ersatzschaltbild eines ersten Ausführungsbeispiels einer Unterschalteinheit;
- Fig. 3: ein Ersatzschaltbild eines zweitens Ausführungsbeispiels einer Unterschalteinheit als High-Side Treiber.

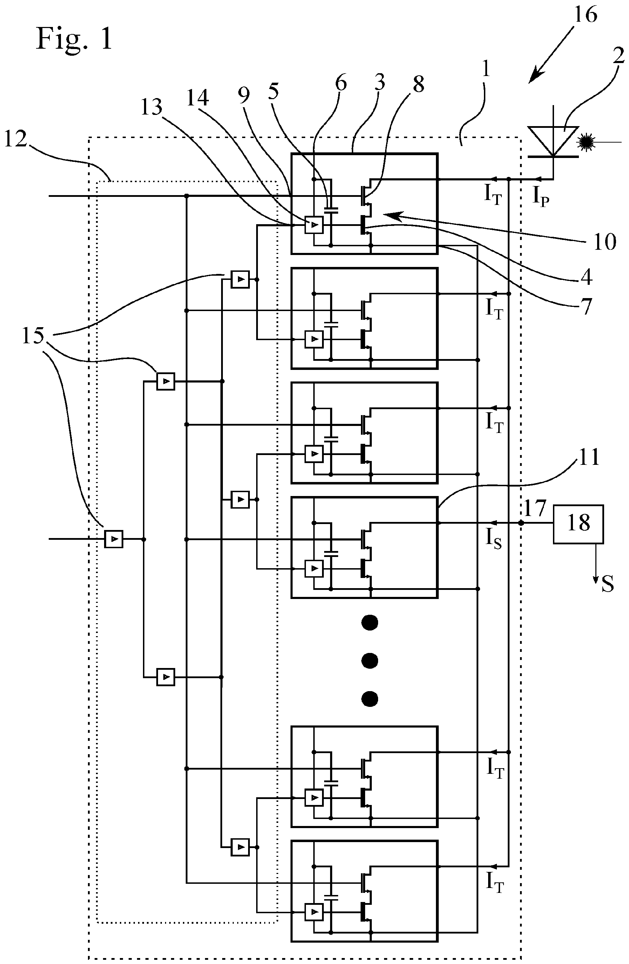

In der Fig. 1 ist in schematischer Weise ein Ersatzschaltbild einer erfindungsgemäßen integrierten Lasertreiberschaltung 1 dargestellt, welche zum Schalten eines Pulsstroms I_{P} für eine Laserdiode 2 dient. Derartige integrierte Lasertreiberschaltungen 1 können in vielen Bereichen der Technik zum Schalten einer Laserdiode 2 Anwendung finden. So sind beispielsweise Anwendungen im sicherheitstechnischen Bereich, aber auch etwa in der Fahrzeugtechnik im Bereich von LIDAR-Sensoren oder dergleichen bekannt.

Die integrierte Lasertreiberschaltung 1 besteht aus einer Mehrzahl von Unterschalteinheiten 3, welche jeweils zum Erzeugen eines Teilstroms I_{T} ausgebildet sind. In der Fig. 1 sind lediglich exemplarisch fünf Unterschalteinheiten 3 dargestellt, welche zueinander parallel geschaltet sind. Die Erfindung ist hierauf jedoch nicht beschränkt. So sind beispielsweise auch Ausgestaltungen denkbar bei welchen 100, 1000 oder eine beliebige andere Anzahl an Unterschalteinheiten 3 verwendet werden. Durch die Integration einer Vielzahl von im Wesentlichen identischen Unterschalteinheiten 3, die jeweils für sich voll funktionsfähig sind, nebeneinander auf einem gemeinsamen Halbleitersubstrat, ist es auf einfache Art und Weise möglich, eine Lasertreiberschaltung 1 zu optimieren. Dabei werden die Unterschalteinheiten 3 derart miteinander verschaltet, dass die einzelnen Funktionen, die die Unterschalteinheiten 3 jeweils durchführen, in ihrer Wirkung vorzugsweise erhalten addiert werden, während sich die Treiberströme addieren. Im Ergebnis weist die integrierte Lasertreiberschaltung 1 dann die gleichen parametrischen Eigenschaften, wie beispielsweise Geschwindigkeit, Pulsform, Spannungsabhängigkeit, Temperaturgang wie eine einzelne Unterschalteinheit 3 auf. Demzufolge ist es ausreichend, die einzelnen Unterschalteinheiten 3 zu verbessern, um so eine optimierte Gesamtschaltung 1 zu realisieren.

Wie dies die Fig. 1 weiter zeigt, weisen die Unterschalteinheiten 3 jeweils den gleichen schaltungstechnischen Aufbau auf. Insbesondere enthalten die Unterschalteinheiten 3 die gleichen passiven und aktiven Bauelemente. Auch hinsichtlich ihrer Funktion und des Layouts sind die Unterschalteinheiten 3 identisch ausgebildet. Die einzelnen Unterschaltkreise 3 der Lasertreiberschaltung 1 sind gemäß dem vorliegenden Ausführungsbeispiel spaltenartig auf einem nicht näher dargestellten Halbleitersubstrat angeordnet. Die Erfindung ist hierauf jedoch nicht beschränkt. Vielmehr ist es möglich, das Layout je nach Bedarf anzupassen, so dass ein optimiertes Gesamtdesign realisiert werden kann.

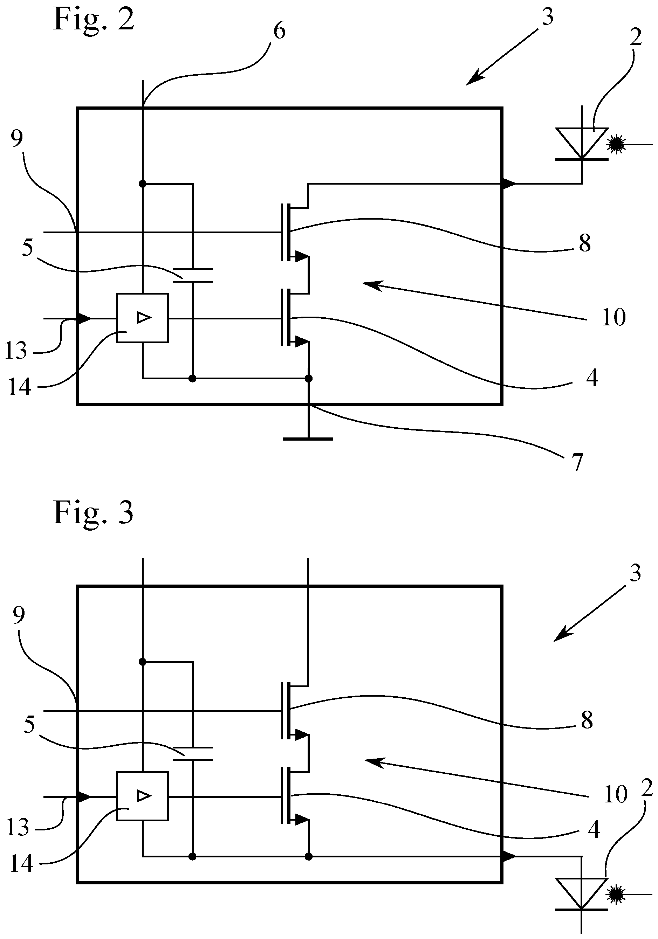

Der Aufbau und die Funktionsweise eines ersten Ausführungsbeispiels einer Unterschalteinheit 3 sollen nachfolgend anhand der Darstellung in der Fig. 2 näher erläutert werden.

Gemäß dem ersten Ausführungsbeispiel weist die Unterschalteinheit 3 eine Teilstromerzeugungseinheit 10 auf, welche mindestens eine Stromquelle 8 sowie einen Schalter 4 umfasst. Der Teilstrom I_{T} wird mittels der Stromquelle 8 erzeugt. Die Stromquelle 8 ist vorliegend als ein Transistor ausgebildet, welcher über einen Referenzeingang 9 angesteuert werden kann. An dem Referenzeingang 9 kann eine Referenzspannung angelegt werden, etwa über eine Gleichspannungsquelle, welche zum Einstellen des Arbeitspunktes und zum Einstellen des Teilstroms I_{T} dient. Die Stromquelle 8 wird über einen zu der Stromquelle 8 in Reihe geschalteten Schalter 4 geschaltet und insbesondere der Teilstrom I_{T} mittels des Schalters 4 gepulst. Der Schalter 4 ist ebenfalls als Transistor ausgebildet und über eine elektronische Schaltung 14, welche einen Verstärker, einen Pulsformer, eine Signalaufbereitung und/oder eine Ansteuerungselektronik enthalten kann, mit einem Steuereingang 13 der Unterschalteinheit 3 verbunden.

Die in der Fig. 2 dargestellte Unterschalteinheit 3 ist als eine Low-Side-Treiberschaltung 1 ausgebildet, was bedeutet, dass die Last gegen Masse geschaltet wird. Eine solche Lasertreiberschaltung 1 bietet insbesondere Vorteile hinsichtlich der Ansteuerung und dem Pulsverhalten. Es sind aber auch Ausgestaltungen einer Lasertreiberschaltung 1 denkbar, bei welchen die Unterschalteinheit 3 als eine High-Side-Treiberschaltung 1 ausgebildet ist. Ein solches Ausführungsbeispiel zeigt Fig. 3. In diesem Fall wird die Last gegen die Versorgungsspannung geschaltet.

Zur Ansteuerung der einzelnen Unterschalteinheiten 3 kann ein Steuersignal über eine Steuerschaltung 12 an die Steuereingänge 13 angelegt werden. Die Steuerschaltung 12, welche ebenfalls auf dem Substrat des integrierten Lasertreibers 1 angeordnet sein kann, ist vorliegend derart ausgebildet, dass die Teilstromerzeugungseinrichtungen 10 der Unterschalteinheiten 3 jeweils gleichzeitig angesteuert werden. Das Steuersignal kann dabei auf unterschiedliche Weise bereitgestellt werden. Gemäß dem vorliegenden Ausführungsbeispiel ist die Steuerschaltung 12 als eine binäre Verstärkerbaumstruktur mit mehreren Verstärkerelementen 15 ausgebildet, welche sich in Richtung der Unterschalteinheiten 3 immer weiter verzweigt. Eine entsprechende Dimensionierung der Verstärkerelemente 15 innerhalb der Baumstruktur führt dazu, dass das von außen bereitgestellte Steuersignal verstärkt und ggf. verzögert wird, aber zeitgleich an den Eingängen 13 der Unterschalteinheiten 3 anliegt. Auf diese Weise lässt sich die Ansteuerung der Unterschalteinheiten 3 präzisieren und ein gleichzeitiger Schaltvorgang aller Unterschalteinheiten 3 kann gewährleistet werden, so dass alle Unterschalteinheiten 3 mit einem einzigen Steuersignal schnell und effizient angesteuert werden. Insbesondere kann ein Laserpuls durch zwei insbesondere phasenverschobene Eingangssignale erzeugt werden.

Um nun auch hohe Ströme im Ampere-Bereich innerhalb kürzester Schaltzeiten, bevorzugt im Picosekunden-Bereich, schalten zu können, ist bei der vorliegenden Erfindung vorgesehen, dass in den Unterschalteinheiten 3 jeweils ein Energiespeicher 5 zum Bereitstellen der zum Schalten des Schalters 4 erforderlichen Schaltenergie integriert ist. Die zum Schalten des Schalters 4 erforderliche Schaltenergie kann so in den einzelnen Unterschalteinheiten 3 vorgehalten werden, so dass die für den Schaltvorgang erforderliche Schaltenergie über das Ansteuerelement 14, das insbesondere ein Verstärker ist oder einen Verstärker umfasst, direkt zur Verfügung gestellt wird. Auf diese Weise kann ein Zusammenbrechen der Versorgungsspannung für das Ansteuerelement 14 verhindert und diese so stabilisiert werden. Der Energiespeicher 5 kann dann bei einem hohen Strom- bzw. Leistungsbedarf, wie dieser während des Schaltvorgangs auftritt, als Spannungs- und/oder Energiequelle wirken. Darüber hinaus wird eine gegenseitige Beeinflussung der einzelnen Unterschalteinheiten 3 verhindert, wodurch sich Pulse mit hoher Flankensteilheit erzeugen lassen.

Der Energiespeicher 5 ist dabei in jeder Unterschalteinheit 3 zwischen dem Versorgungsanschluss 6 zum Anlegen einer Versorgungsspannung und den Masseanschluss 7 jeder Unterschalteinheit 3 geschaltet. Auf diese Weise kann die zum Schalten des Schalters 4 erforderliche Schaltenergie am Gate des Transistors 4 bereitgestellt werden, derart dass sichergestellt werden kann, dass die am Versorgungsanschluss 6 anliegende Versorgungsspannung für das Ansteuerelement 14 im Schaltmoment nicht einbricht. Durch eine Verschaltung des Energiespeichers 5 zwischen den Versorgungsanschluss 6 und den Masseanschluss 7 kann diese Versorgungsspannung, insbesondere während des Schaltvorgangs, lokal stabilisiert werden. Der Energiespeicher 5 ist parallel zur Versorgungsspannung geschaltet, so dass der Energiespeicher 5 als lokal stützende Spannungs- und/oder Energiequelle wirken kann. Stromspitzen können auf diese Weise zuverlässig ausgeglichen und die zum Umladen des Schalters 4 erforderliche Schaltenergie bereitgestellt werden.

Im vorliegenden Ausführungsbeispiel der Lasertreiberschaltung 1 ist der Energiespeicher 5 als ein Kondensator und insbesondere als ein Stützkondensator mit niedriger Impedanz bei hohen Frequenzen ausgebildet. Dadurch werden zusätzlich störende zeitlich begrenzte Überspannungen aufgenommen und so deren Ausbreitung und schädliche Wirkung vermindert. Der Kondensator 5 weist eine Kapazität im Nanofarad- oder im Picofarad-bereich auf, besonders bevorzugt jedoch im Picofaradbereich. Um parasitäre Effekte zu vermeiden ist der Kondensator 5 über einen kurzen und induktivitätsarmen Anschluss angeschlossen. Durch entsprechend kurz ausgebildet Leitungen und/oder groß gewählte Querschnitte der Leiterbahnen ist der Energiespeicher 5 niederinduktiv angebunden. Durch die räumliche Nähe zum Schalter 4 werden hohe Induktivitäten vermieden, weshalb bei Stromspitzen sofort Strom geliefert werden kann und sich so Spannungsabfälle in Grenzen halten. Gleichzeitig können die hohen Ströme nur auf dem kurzen Weg fließen, so dass die dadurch hervorgerufenen EMV-Störungen stark bedämpft werden können. Instabilitäten und ein Aufschwingen der integrierten Lasertreiberschaltung 1 können auf diese Weise verhindert werden. Im Falle einer High-Side-Treiberschaltung 1 kann der Energiespeicher 5 als Bootstrap-Kondensator dienen.

Vorteilhaft ist es, wenn der Kondensator 5 als ein Metall-Isolator-Metall-(MIM) Kondensator, Fringe-Kondensator, Poly-Poly-Kondensator, als Diffusions-Kondensator und/oder als Gate-Kondensator ausgebildet ist. Besonders vorteilhaft ist jedoch, dass je nach Layout-Design eine Kombination der verschiedenen Kondensator-Arten verwendet wird. Gemäß dem vorliegenden Ausführungsbeispiel ist der Energiespeicher 5 als Metall-Isolator-Metall-Kondensator 5 ausgebildet. Dabei wird mindestens zumindest eine Elektrode des Kondensators 5 durch eine in der Unterschalteinheit 3 vorhandene Metallfläche, wie beispielsweise eine Leiterbahn oder dergleichen, gebildet. Im Rahmen des Fertigungsprozesses wird auf diese Metallfläche eine Isolatorschicht sowie bei Bedarf eine weitere Gegenelektrode aufgebracht. Werden für beide Elektroden des Kondensators 5 vorhandene Metallflächen verwendet, so wird die Isolatorschicht zwischen diesen beiden Metallflächen angeordnet. Auf diese Weise lässt sich bei gleichzeitig hoher Kapazität eine platzsparende Anordnung erzeugen. Die Kondensatoren 5 weisen bevorzugt einen hohen Kapazitätsbelag auf, wobei durch die Kombination der einzelnen Kondensatorarten der Kapazitätsbelag zusätzlich erhöht werden kann.

Da die Unterschalteinheiten 3 aufgrund ihrer Bauteile gewisse parasitäre Effekte aufweisen, wie beispielsweise Verzögerungen oder ein temperaturabhängiges Verhalten, kann in der Lasertreiberschaltung 1 ein Delay entstehen, welches sich als nachteilig erwiesen hat. Um diese parasitären Effekte detektieren und eliminieren zu können, ist, wie dies Fig. 1 weiter zeigt, zusätzlich zu den Unterschalteinheiten 3 eine Synchronisationseinheit 11 zur Synchronisierung der Eingangs- und Ausgangssignale vorgesehen.

Die Synchronisationseinheit 11 ist im Wesentlichen identisch mit den Unterschalteinheiten 3. Gemäß dem in der Fig. 1 dargestellten Ausführungsbeispiel weist die Synchronisationseinheit 11 ein zu den Unterschalteinheiten 13 identisches elektrisches Temperatur- und/oder Zeitverhalten auf, insbesondere deshalb, da hier identische Bauteile vorgesehen sind. Insbesondere ist auch in der Synchronisationseinheit 11 die gleiche Teilstromerzeugungseinheit 10 wie in den Unterschalteinheiten 3 vorgesehen.

Im Gegensatz zu den Ausgängen der Unterschalteinheiten 3 ist der Ausgang 17 der Synchronisationseinheit 11, über den der Synchronisationsstrom Is geführt wird, jedoch nicht mit den anderen Ausgängen der Unterschalteinheiten 3 zusammengeführt, sondern wird als Sync-Ausgang 17 separat nach außen geführt, insbesondere zu einer separaten Synchronisationsschaltung 18. Auf diese Weise lässt sich, insbesondere mittels der Synchronisationsschaltung 18, ein Synchronisationssignal S erzeugen, welches zur Synchronisierung mit dem summierten Treiberstrom I_{P} oder dem mit der Laserdiode 2 erzeugten Lichtpuls herangezogen werden kann. Der summierte Treiberstrom I_{P} weist das gleiche Zeitverhalten wie die Teilströme I_{T} der Unterschalteinheiten 3 und/oder wie der Synchronisationsstrom Is der Synchronisationseinheit 11 auf. Über den Sync-Ausgang 17 und/oder mit dem Synchronisationssignal S kann damit der definierte elektrische Schaltzeitpunkt der Laserdiode 2 ausgegeben werden. Bei Kenntnis der elektro-optischen Umsetzungszeit der Laserdiode 2 ist auch der genaue Lichtemissionszeitpunkt der Laserdiode 2 bekannt und kann bei dem Synchronisationssignal S berücksichtigt werden. Beispielsweise kann im Falle eines LIDAR-Systems der Synchronisationsstrom Is zu einer Synchronisation eines das Laserlicht empfangenden Sensors als Grundlage für die genaue time-of-flight Messung herangezogen werden. Es kann somit auf ein ansonsten aufwändiges und kompliziertes Synchronisierungsverfahren verzichtet werden.

Anstelle eines hinsichtlich der verwendeten Bauteile identischen Aufbaus der Synchronisationseinheit 11 sind auch Ausgestaltungen denkbar, bei welchen die in den Teilstromerzeugungseinheiten 10 vorhandenen Elemente gedoppelt und in ihrer Größe halbiert werden. In diesem Fall sind dann bevorzugt zwei Teilstromerzeugungseinheiten 10 innerhalb der Synchronisationseinheit 11 vorhanden. Die so gedoppelten Elemente können dann zueinander parallel oder antiparallel geschaltet werden. Hierdurch kann insbesondere ein differentielles Ausgangssignal erzeugt werden. Hierdurch lassen sich zusätzliche Signale erzeugen, welche insbesondere für die schaltungstechnische Nachbearbeitung von Vorteil sind. Dennoch weist die Synchronisationseinheit 11 jedoch das gleiche Zeitverhalten wie die Unterschalteinheiten 3 auf.

Die integrierte Lasertreiberschaltung 1 kann zusammen mit der Laserdiode 2 ein Lasersystem 16 bilden. Dabei ist es von Vorteil, wenn die Laserdiode 2 auf der integrierten Lasertreiberschaltung 1 als Substrat angeordnet ist. Auf diese Weise kann die Baugröße weiter verringert werden. In einem solchen Lasersystem 16 kann die integrierte Lasertreiberschaltung 1 das Substrat bilden, wobei die Laserdiode wärmeleitend über Stacked Vias mit dem Substrat verbunden ist. Dabei kann insbesondere eine direkte metallische Verbindung zum Substrat zur Wärmeabfuhr zwischen der Laserdiode 2 und der Treiberschaltung 1 bestehen. Die Ausgangsanschlüsse und die Masseanschlüsse aller Unterschalteinheiten 3 sind auf dem Substrat zusammengeschaltet. Die zusammengeschalteten Ausgangsanschlüsse sind mit der Kathode der Laserdiode 2 verbunden, deren Anode wiederum mit einer Versorgungsquelle verbunden ist, die gegenüber Masse eine Betriebsspannung liefert.

Mit einer erfindungsgemäßen integrierten Lasertreiberschaltung 1, welche eine Mehrzahl von im Wesentlichen identisch ausgebildeten Unterschalteinheiten 3 aufweist, kann auf einfache Art und Weise eine skalierbarere Hochgeschwindigkeitsstromtreiberschaltung 1 für eine Laserdiode 2 aufgebaut werden. Die Unterschalteinheiten 3 können jeweils optimal für einen kleinen Teilstrom I_{T} ausgelegt sein, welche zu einem Pulsstrom I_{P} addiert werden, so dass im Ergebnis auch die Gesamtschaltung 1 für einen hohen Strom I_{P} von einigen Ampere bis zu einigen hundert Ampere optimiert ist. Durch das Vorsehen eines Energiespeichers 5 innerhalb jeder Unterschalteinheit 3 kann die für das Schalten des Schalters 4 erforderliche Schaltenergie insbesondere für einen oder mehrere Pulse bereitgestellt werden und so ein Einbrechen der lokalen Versorgungsspannung verhindert werden. Auf diese Weise lassen sich extrem schnelle Schaltzeiten mit hoher Flankensteilheit realisieren.

### Bezugszeichen:

- 1: Integrierte Lasertreiberschaltung
- 2: Laserdiode
- 3: Unterschalteinheit
- 4: Schalter
- 5: Energiespeicher
- 6: Versorgungsanschluss
- 7: Masseanschluss
- 8: Stromquelle
- 9: Referenzeingang
- 10: Teilstromerzeugungseinheit
- 11: Synchronisationseinheit
- 12: Steuerschaltung
- 13: Steuereingang
- 14: Ansteuerelement
- 15: Verstärkerelement
- 16: Lasersystem
- 17: Sync-Ausgang
- 18: Synchronisationsschaltung

- I_{P}: Pulsstrom
- I_{T}: Teilstrom
- S: Synchronisationssignal

## Patentansprüche

1. Integrierte Lasertreiberschaltung zum Schalten eines Pulsstroms (I_{P} ) für eine Laserdiode (2) mit einer Mehrzahl von Unterschalteinheiten (3) zum Erzeugen jeweils eines Teilstroms (I_{T}) mit einem Schalter (4) zum Pulsen des Teilstroms (I_{T}), wobei die Unterschalteinheiten (3) zur Erzeugung des Pulsstroms (I_{P} ) zueinander parallel geschaltet sind,
**dadurch gekennzeichnet,**
**dass** in den Unterschalteinheiten (3) jeweils ein Energiespeicher (5) zum Bereitstellen der zum Schalten des Schalters (4) erforderlichen Schaltenergie integriert ist, dass jede Unterschalteinheit (3) einen lokalen Versorgungsanschluss (6) zum Anlegen einer Versorgungsspannung und einen lokalen Masseanschluss (7) aufweist, wobei der Energiespeicher (5) zwischen den Versorgungsanschluss (6) und den Masseanschluss (7) geschaltet ist und dass der Energiespeicher (5) als ein Kondensator ausgebildet ist.

2. Integrierte Lasertreiberschaltung nach Anspruch 1, **dadurch gekennzeichnet, dass** der Kondensator (5) als Metall-Isolator-Metall-Kondensator und/oder als Fringe-Kondensator und/oder als Poly-Poly-Kondensator und/oder als Diffusions-Kondensator und/oder als Gate-Kondensator ausgebildet ist.

3. Integrierte Lasertreiberschaltung nach Anspruch 2, **dadurch gekennzeichnet, dass** bei einem Metall-Isolator-Metall-Kondensator (5) zumindest eine Elektrode des Kondensators (5) durch eine im Unterschaltkreis vorhandene Metallfläche gebildet wird.

4. Integrierte Lasertreiberschaltung nach einem der vorhergehenden Ansprüche, **dadurch gekennzeichnet, dass** jede Unterschalteinheit (3) zur Erzeugung des Teilstroms (I_{T}) eine Stromquelle (8), insbesondere einen Transistor, aufweist, welche über den Schalter (4) schaltbar ist.

5. Integrierte Lasertreiberschaltung nach einem der vorhergehenden Ansprüche, **gekennzeichnet durch** mindestens eine Synchronisationseinheit (11) zur Synchronisierung der Eingangs- und Ausgangssignale, welche zu den Unterschalteinheiten (3) parallel geschaltet ist.

6. Integrierte Lasertreiberschaltung nach Anspruch 5, **dadurch gekennzeichnet, dass** die Synchronisationseinheit (11) das gleiche Zeitverhalten aufweist wie die Unterschalteinheiten (3).

7. Integrierte Lasertreiberschaltung nach einem der Ansprüche 5 oder 6, **dadurch gekennzeichnet, dass** die Synchronisationseinheit (11) und die Unterschalteinheiten (3) hinsichtlich der Erzeugung des Teilstroms (I_{T}) im Wesentlichen identisch ausgebildet sind.

8. Integrierte Lasertreiberschaltung nach einem der Ansprüche 5 bis 7, **dadurch gekennzeichnet, dass** die Synchronisationseinheit (11) mindestens zwei Teilstromerzeugungseinheiten (10) mit jeweils einem Ausgang aufweist, die parallel oder antiparallel schalten.

9. Integrierte Lasertreiberschaltung nach einem der vorhergehenden Ansprüche, **dadurch gekennzeichnet, dass** die Unterschalteinheiten (3) und/oder die Synchronisationseinheit (11) mittels einer Steuerschaltung (12) derart ansteuerbar sind, dass alle Unterschalteinheiten (3) und/oder die Synchronisationseinheit (11) gleichzeitig schaltbar sind.

10. Integrierte Lasertreiberschaltung nach einem Anspruch 9, **dadurch gekennzeichnet, dass** die Steuerschaltung (12) als binäre Verstärkerbaumstruktur ausgebildet ist.

11. Integrierte Lasertreiberschaltung nach einem der vorhergehenden Ansprüche, **dadurch gekennzeichnet, dass** die Schaltung (1) als High-Side-Treiberschaltung oder als Low-Side Treiberschaltung ausgebildet ist.

12. Integrierte Lasertreiberschaltung nach Anspruch 11, **dadurch gekennzeichnet, dass** der Energiespeicher (5) in einer High-Side-Treiberschaltung (1) als Bootstrap-Kondensator ausgebildet ist.

13. Lasersystem mit mindestens einer Laserdiode (2) und mindestens einer integrierten Lasertreiberschaltung (1) nach einem der vorhergehenden Ansprüche.

14. Lasersystem nach Anspruch 13, **dadurch gekennzeichnet, dass** die Laserdiode (2) auf der integrierten Lasertreiberschaltung (1) angeordnet ist.

15. Lasersystem nach einem der Ansprüche 13 oder 14, **dadurch gekennzeichnet, dass** die integrierte Lasertreiberschaltung (1) als Substrat ausgebildet ist und dass die Laserdiode (2) wärmeleitend über Stacked Vias mit diesem Substrat verbunden ist.

16. Lasersystem nach einem der Ansprüche 13 bis 15, **dadurch gekennzeichnet, dass** ein Laserpuls durch zwei insbesondere phasenverschobene Eingangssignale erzeugbar ist.

## Claims

1. An integrated laser driver circuit for switching a pulse current (I_{P}) for a laser diode (2) having a plurality of sub-switching units (3) for generating in each case a partial current (I_{T}) using a switch (4) for pulsing the partial current (I_{T}), wherein the sub-switching units (3) are connected to one another in parallel for generating the pulse current (I_{P}),
**characterized in that**
an energy accumulator (5) is integrated into each of the sub-switching units (3) to provide the switching energy required for switching the switch (4), **in that** each sub-switching unit (3) comprises a local supply terminal (6) for applying a supply voltage and a local ground terminal (7), wherein the energy accumulator (5) is connected between the supply terminal (6) and the ground terminal (7) and **in that** the energy accumulator (5) is designed as a capacitor.

2. The integrated laser driver circuit as claimed in claim 1, **characterized in that** the capacitor (5) is designed as a metal-insulator-metal capacitor and/or as a fringe capacitor and/or as a poly-poly capacitor and/or as a diffusion capacitor and/or as a gate capacitor.

3. The integrated laser driver circuit as claimed in claim 2, **characterized in that**, in a metal-insulator-metal capacitor (5), at least one electrode of the capacitor (5) is formed by a metal surface provided in the sub-switching circuit.

4. The integrated laser driver circuit as claimed in any one of the preceding claims, **characterized in that** each sub-switching unit (3) comprises a current source (8), in particular a transistor, which is switchable via the switch (4), for generating the partial current (I_{T}).

5. The integrated laser driver circuit as claimed in any one of the preceding claims, **characterized by** at least one synchronization unit (11) for synchronizing the input and output signals, which is connected in parallel to the sub-switching units (3).

6. The integrated laser driver circuit as claimed in claim 5, **characterized in that** the synchronization unit (11) has the same time behavior as the sub-switching units (3).

7. The integrated laser driver circuit as claimed in one of claims 5 or 6, **characterized in that** the synchronization unit (11) and the sub-switching units (3) are designed substantially identically with respect to the generation of the partial current (I_{T}).

8. The integrated laser driver circuit as claimed in any one of claims 5 to 7, **characterized in that** the synchronization unit (11) comprises at least two partial current generating units (10) each having an output, which switch in parallel or antiparallel.

9. The integrated laser driver circuit as claimed in any one of the preceding claims, **characterized in that** the sub-switching units (3) and/or the synchronization unit (11) are activatable by means of a control circuit (12) in such a way that all sub-switching units (3) and/or the synchronization unit (11) are switchable simultaneously.

10. The integrated laser driver circuit as claimed in claim 9, **characterized in that** the control circuit (12) is designed as a binary amplifier tree structure.

11. The integrated laser driver circuit as claimed in any one of the preceding claims, **characterized in that** the circuit (1) is designed as a high-side driver circuit or as a low-side driver circuit.

12. The integrated laser driver circuit as claimed in claim 11, **characterized in that** the energy accumulator (5) in a high-side driver circuit (1) is designed as a bootstrap capacitor.

13. A laser system having at least one laser diode (2) and at least one integrated laser driver circuit (1) as claimed in any one of the preceding claims.

14. The laser system as claimed in claim 13, **characterized in that** the laser diode (2) is arranged on the integrated laser driver circuit (1).

15. The laser system as claimed in one of claims 13 or 14, **characterized in that** the integrated laser driver circuit (1) is designed as a substrate, and **in that** the laser diode (2) is connected in a thermally-conductive manner via stacked vias to this substrate.

16. The laser system as claimed in any one of claims 13 to 15, **characterized in that** a laser pulse can be generated by two input signals, which are phase-shifted in particular.

## Revendications

1. circuit intégré de commande de laser pour la commutation d'un courant d'impulsion (I_{P} ) pour une diode laser (2) avec une pluralité d'unités de sous-commutation (3) pour la production respectivement d'un courant partiel (IT) avec un commutateur (4) pour la pulsation du courant partiel (IT), les unités de sous-commutation (3) étant montées en parallèle les unes avec les autres pour la production du courant d'impulsion (I_{P} ),
**caractérisé en ce que**
**en ce qu'**un accumulateur d'énergie (5) est intégré dans chacune des unités de sous-commutation (3) pour fournir l'énergie de commutation nécessaire à la commutation du commutateur (4), **en ce que** chaque unité de sous-commutation (3) présente une connexion d'alimentation locale (6) pour appliquer une tension d'alimentation et une connexion de masse locale (7), l'accumulateur d'énergie (5) étant connecté entre la connexion d'alimentation (6) et la connexion de masse (7), et
**en ce que** l'accumulateur d'énergie (5) est conçu comme un condensateur.

2. Circuit intégré de commande de laser selon la revendication 1, **caractérisé en ce que** le condensateur (5) est conçu comme un condensateur métal-isolant-métal et/ou comme un condensateur à franges et/ou comme un condensateur poly-poly et/ou comme un condensateur à diffusion et/ou comme un condensateur à grille.

3. Circuit intégré de commande laser selon la revendication 2, **caractérisé en ce que**, dans le cas d'un condensateur métal-isolant-métal (5), au moins une électrode du condensateur (5) est formée par une surface métallique présente dans le sous-circuit.

4. Circuit intégré de commande de laser selon l'une des revendications précédentes, **caractérisé en ce que** chaque unité de sous-commutation (3) présente une source de courant (8), notamment un transistor, pour générer le courant partiel (IT), laquelle peut être commutée par le commutateur (4).

5. Circuit intégré de commande de laser selon l'une des revendications précédentes, **caractérisé par** au moins une unité de synchronisation (11) pour la synchronisation des signaux d'entrée et de sortie, qui est montée en parallèle avec les unités de sous-commutation (3).

6. Circuit intégré de commande de laser selon la revendication 5, **caractérisé en ce que** l'unité de synchronisation (11) présente le même comportement temporel que les unités de commutation secondaires (3).

7. Circuit intégré de commande laser selon l'une des revendications 5 ou 6, **caractérisé en ce que** l'unité de synchronisation (11) et les unités de sous-commutation (3) sont conçues de manière essentiellement identique en ce qui concerne la génération du courant partiel (IT).

8. Circuit intégré de commande laser selon l'une des revendications 5 à 7, **caractérisé en ce que** l'unité de synchronisation (11) comporte au moins deux unités de génération de courant partiel (10) avec chacune une sortie, qui commutent en parallèle ou en antiparallèle.

9. Circuit intégré de commande de laser selon l'une des revendications précédentes, **caractérisé en ce que** les unités de sous-commutation (3) et/ou l'unité de synchronisation (11) peuvent être commandées au moyen d'un circuit de commande (12) de telle sorte que toutes les unités de sous-commutation (3) et/ou l'unité de synchronisation (11) puissent être commutées simultanément.

10. Circuit intégré de commande de laser selon une revendication 9, **caractérisé en ce que** le circuit de commande (12) est conçu comme une structure arborescente d'amplificateur binaire.

11. Circuit intégré de commande laser selon l'une des revendications précédentes, **caractérisé en ce que** le circuit (1) est conçu comme un circuit de commande côté haut ou comme un circuit de commande côté bas.

12. Circuit intégré de commande de laser selon la revendication 11, **caractérisé en ce que** l'accumulateur d'énergie (5) dans un circuit de commande côté haut (1) est conçu comme un condensateur bootstrap.

13. Système laser comprenant au moins une diode laser (2) et au moins un circuit intégré de commande laser (1) selon l'une des revendications précédentes.

14. système laser selon la revendication 13, **caractérisé en ce que** la diode laser (2) est disposée sur le circuit intégré de commande laser (1).

15. Système laser selon l'une des revendications 13 ou 14, **caractérisé en ce que** le circuit intégré de commande laser (1) est réalisé sous forme de substrat et **en ce que** la diode laser (2) est reliée à ce substrat par conduction thermique via des vias empilées.

16. Système laser selon l'une des revendications 13 à 15, **caractérisé en ce qu'**une impulsion laser peut être générée par deux signaux d'entrée, notamment déphasés.
